# EUROPEAN PATENT APPLICATION

(11) **EP 4 788 076 A1**
(43) Date of publication of application: **05.08.2026**
(21) Application number: 26156340.7
(22) Date of filing: 04.02.2026
(51) Int. Cl.: H05K 7/20

(54) **SYSTEM AND METHOD FOR POWER AWARE CHILLER CONTROL**

(30) Priority: 04.02.2025 US 202563753723 P; 30.01.2026 US 202619465133
(71) Applicant: Vertiv Corporation, Westerville, OH 43082 (US)
(72) Inventor: TAKACS, Balint, Westerville, 43082 (US); BARBATO, Pierpaolo, Westerville, 43082 (US); VOIGT, Tyler William, Westerville, 43082 (US)
(74) Representative: Cousens, Nico

(57) **Abstract**

A system and method for power aware thermal management of a data center environment including IT devices receiving operating power from power distribution units (PDU) may include sensing current cooling capacity of a cooling system including chiller devices for transferring thermal energy generated by the IT devices by circulating a fluid refrigerant through the IT devices via a fluid network. Similarly, the PDUs may sense and report current operating power distributed to the IT devices. A cooling system controller may, when current power distribution data sufficiently deviates from the current cooling capacity (e.g., indicative of an imminent surge or drop in power and a corresponding shift in heat load), direct the chiller devices to adjust device setpoints to proactively address the imminent shift in heat load within the fluid network.

## Description

The present application claims the benefit under 35 U.S.C. § 119(e) of U.S. Provisional Patent Application Serial Number 63/753,723 filed February 4, 2025.

### TECHNICAL FIELD

The present disclosure is directed generally to the field of cooling systems for data centers and similar controlled-temperature environments, and more particularly, to monitoring of two-phase pumping systems within a cooling system.

### BACKGROUND

Data center environments incorporate multiple systems in addition to the servers and other information technology (IT) equipment operating therein. For example, the IT equipment is housed in racks. Power distribution units (PDU) deliver operating power to the IT devices and monitor power usage. Coolant distribution units (CDU) circulate air-cooled or liquid-cooled refrigerant through the IT equipment to absorb heat generated by the processors thereof. Chiller devices transfer and dissipate heat from the CDUs, generally to an exterior ambient environment, and resupply the CDUs with a cooled medium.

These diverse systems operate in parallel, but they do not operate cooperatively as there is no information sharing, no state sharing, and generally no communication among their components. This system isolation presents a problem when, for example, a surge or spike in the demand for operating power by the IT equipment (as is often characteristic of generative artificial intelligence (AI) or other like high-performance computing (HPC) applications creates a corresponding heat load wave for the CDU and chiller to remove from the system. However, the CDU and chiller are unaware of this wave until the refrigerant begins to return to the CDU at an elevated temperature. Because of this system inertia, cooling systems are executing a delayed reaction to an event that has already occurred.

### SUMMARY

In a first aspect, a power-aware cooling system for a data center environment is disclosed. In embodiments, the cooling system includes servers, switches, or other information technology (IT) devices within the environment and power distribution units (PDU) for providing operating power to the IT devices. The system may include cooling or chiller devices for transferring heat generated by the IT devices (e.g., converted from operating power) by circulating a fluid refrigerant through a fluid network to and from the IT devices based on chiller device setpoints. The chiller devices may further sense current cooling capacity parameters. The cooling system controller may receive current power distribution data sensed by the PDUs and current cooling capacity data sensed by the chiller devices. When, for example, the power distribution data sufficiently deviates from the cooling capacity data (e.g., the power distribution data is indicative of an imminent surge or drop in operating power not yet otherwise detected within the cooling system) the controller may direct the chiller devices to adjust the current chiller setpoints to address the corresponding shift in heat load within the cooling system.

In some embodiments, the cooling system may monitor trending cooling capacity data over a first duration prior to the current time (e.g., a past time window) and may monitor trending power distribution data over a second duration prior to the current time (e.g., a recent time window).

In some embodiments, the past time window is longer than the recent time window.

In some embodiments, the chiller setpoints include predetermined or desired outlet temperatures for refrigerant leaving a chiller device. For example, predetermined or desired setpoints may be based on an expected power distribution level throughout the system. Similarly, sensed cooling capacity data may include current outlet temperatures sensed within the chiller device or fluid network.

In some embodiments, the chiller setpoints include predetermined or desired outlet temperatures for refrigerant leaving a chiller device. For example, predetermined or desired setpoints may be based on an expected power distribution level throughout the system. Similarly, sensed cooling capacity data may include current outlet temperatures sensed within the chiller device or fluid network.

In some embodiments, the power distribution data includes a cumulative power distribution, e.g., among multiple PDUs providing operating power to various downstream IT devices. For example, the controller may direct chiller devices to adjust chiller setpoints only where the current cumulative power data is indicative of an imminent surge or drop, as opposed to the power distribution provided by any single PDU.

In some embodiments, the cooling system is a direct-to-chip (D2C) cooling system whereby the fluid network is in direct thermal communication with chips and or chip assemblies within the IT devices, e.g., via cold plates or similar thermal transfer devices.

In some embodiments, the controller correlates received cooling capacity data to an equivalent power distribution level, e.g., the level of power distribution manageable at that level of cooling capacity. For example, when actual or sensed power distribution data significantly deviates from this equivalent power distribution level, the controller may direct the chiller devices to adjust the chiller setpoints.

In some embodiments, the cooling system is a two-phase, rather than single-phase, cooling system. For example, the two-phase system may circulate fluid refrigerant through the IT devices via a first fluid network, transferring the absorbed thermal energy to a second fluid network via coolant distribution units (CDUs) including heat exchangers. This second fluid network may carry the transferred thermal energy to chiller devices whereby the thermal energy may be dissipated to the outside air or otherwise removed from the data center environment.

In a further aspect, a method for thermal management of a data center environment including information technology (IT) devices receiving operating power from power distribution units (PDU) is disclosed. The method may include receiving, via a controller of a cooling system, system parameters including power distribution capacities of the PDUs and a required cooling capacity for the cooling system to maintain the data center environment within predetermined acceptable temperature levels. The method may include providing operating power to the IT devices via the PDUs. The method may include circulating a fluid refrigerant through the IT devices via a fluid network to transfer thermal energy generated by the IT devices (e.g., converted from operating power) into the fluid network according to setpoints for chiller devices of the cooling system, the chiller devices responsible for pumping or otherwise circulating the fluid refrigerant. The method may include sensing and reporting current operating power provided to the IT devices via the PDUs. The method may include sensing current cooling capacity within the cooling system, e.g., current settings and parameters of its component chiller devices. The method may include, when current power distribution significantly deviates from current cooling capacity, e.g., indicative of an imminent surge or drop in operating power not otherwise detected within the cooling system, directing the chiller devices to adjust chiller setpoints.

In some embodiments, the method may include monitoring current power distribution data over a first duration prior to a current time (e.g., a recent time window), and monitoring current cooling capacity over a second duration prior to the current time (e.g., a past time window).

In some embodiments, the past time window duration may be longer than the recent time window duration.

In some embodiments, the method may include directing one or more chiller devices to adjust an outlet temperature of fluid refrigerant leaving the chiller device.

In some embodiments, the method may include directing one or more chiller devices to adjust a flow rate of fluid refrigerant leaving the chiller device.

In some embodiments, the method may include determining a cumulative power distribution across two or more PDUs providing operating power. The method may include directing one or more chiller devices to adjust chiller setpoints only when the current cumulative power distribution (e.g., as opposed to the power distribution for any individual PDU) sufficiently deviates from the current cooling capacity data.

In some embodiments, the method may include correlating sensed current cooling capacity data with an equivalent power distribution level, e.g., the amount of operating power manageable by the cooling system under the current cooling capacity, and directing the chiller devices to adjust chiller setpoints when the sensed current power distribution sufficiently deviates from the equivalent power distribution level.

In some embodiments, the cooling system may be a direct-to-chip (D2C) cooling system, and circulating the fluid refrigerant through the IT devices via the fluid network includes circulating the fluid refrigerant into direct thermal communication with chips or chip assemblies within the IT devices, e.g., via cold plates or other appropriate thermal transfer devices.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE FIGURES

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a block diagram of a pumped two-phase cooling system serving one or more IT devices according to example embodiments of the inventive concepts disclosed herein;
FIG. 2 is a block diagram of a single-phase cooling system serving one or more IT devices according to example embodiments of the inventive concepts disclosed herein;
FIG. 3 is a diagrammatic illustration of moving time windows monitored by a controller of the cooling system of FIGS. 1 or 2, relative to system PDU power output and to cooling capacity respectively;
FIG. 4 is a diagrammatic illustration of an operational flow of the cooling system of FIGS. 1 or 2;
FIGS. 5A and 5B are graphical representations of monitoring of PDU power output and cooling capacity over time by the controller of the cooling system of FIGS. 1 or 2, wherein when PDU power output sufficiently deviates from cooling capacity, the controller triggers corrective adjustment; and
FIGS. 6A and 6B are process flow diagrams illustrating a method for thermal management of a cooling system with real time PDU to chiller feedback according to example embodiments of the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to methods and systems for power aware chiller control. Said methods and systems may be "power aware" in that they may incorporate real-time or near real-time responsiveness to surges or spikes in power provided to servers, switches, or other information technology (IT) devices within the environment. For example, these load surges or spikes, which may be characteristic of generative artificial intelligence (AI) or similarly high-performance computing (HPC) applications, may lead to downstream increases in heat load (due to the near total conversion of distributed power to heat). Cooling delivery systems, or chiller systems, configured for maintaining the data center environment within a required temperature range (e.g., below a maximum temperature), have no way of detecting these increases in heat load before their effects reach the chiller system, at which point the chiller system may not be able to efficiently handle the removal of significant additional heat from the system. A power aware system may be informed of, and may respond to, load surges or spikes when they occur, rather than when the thermal consequences of said surges or spikes are detected downstream (at which point an equivalently effective and efficient response may not be possible).

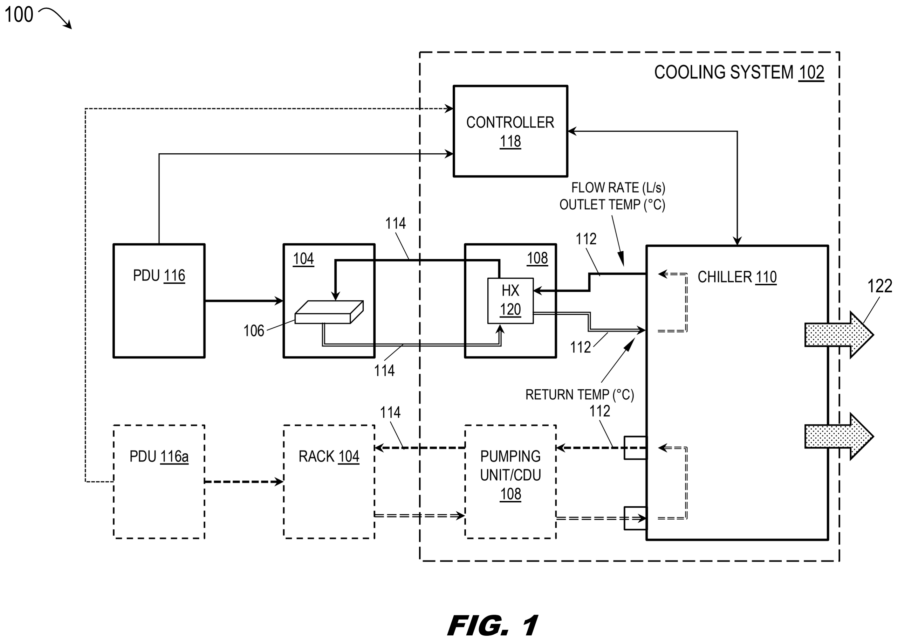

Referring now to FIG. 1, a data center environment 100 served by a pumped cooling system 102 is shown. The data center environment 100 may include racks 104 of IT devices 106 (e.g., servers, switches, and other like processing devices). The cooling system 102 may be a two-phase cooling system including coolant delivery units 108 (CDU; e.g., pumping units), chiller devices 110, primary fluid network 112, secondary fluid network 114, power distribution unit/s 116 (PDU), and supervisory controller 118.

In embodiments, IT devices 106 are housed in racks 104 or rows within the environment 100. For example, each IT device 106 may be provided with operating power by a PDU 116 into which the IT device is plugged or otherwise connected, e.g., directly or indirectly via a rack 104 or shelf in which the IT device is housed or otherwise disposed.

In embodiments, the CDUs 108 may connect the primary fluid network 112 and secondary fluid network 114, e.g., via heat exchanger 120 (HX). For example, the CDUs 108 may circulate a fluid refrigerant through the secondary fluid network 114 such that the fluid refrigerant leaves the pumping units at a particular outlet temperature and at a particular flow rate. When the fluid refrigerant reaches the IT devices 106, heat generated by the IT devices (based on the operating power provided by the PDU 116) is transferred to the fluid refrigerant and returned to the CDUs 108 via the secondary fluid network 114, e.g., at a return temperature higher than the outlet temperature due to the absorbed heat.

In some embodiments, the pumped two-phase cooling system 102 may be a direct-to-chip (D2C) cooling system wherein the secondary fluid network 114 directs fluid refrigerant into thermal communication with chip assemblies. For example, chip assemblies may include cold plates in direct thermal contact with chips and/or processors of the IT devices 106, such that thermal energy generated by the chips/processors may be directly transferred through the cold plates to the secondary fluid network 114 and thereby returned to the CDUs 108.

In embodiments, heat transferred from the IT devices 106 may further be transferred to the primary fluid network 112 via heat exchangers 120 within the CDUs 108. For example, the chiller devices 110 may likewise circulate through the primary fluid network 112 a fluid refrigerant (e.g., water, water/glycol, or a different fluid refrigerant than is circulated through the secondary fluid network 114) that leaves the chiller devices at a particular outlet temperature and/or flow rate. In embodiments, the heat exchangers 120 within the CDUs 108 may transfer absorbed heat from the secondary fluid network 114 to the primary fluid network 112, which returns this transferred heat to the chiller devices 110. Similarly to the secondary fluid network 114, fluid refrigerant circulating through the primary fluid network 112 may return to the chiller devices 110 at a return temperature higher than the outlet temperature. In embodiments, the chiller devices 110 may dissipate absorbed heat from the primary fluid network 112 to external outlets, e.g., directing the absorbed heat into the air outside the environment 100 via fans and air ducts. In this way, the cooling system 102 removes (122) heat from the environment 100 such that conditions within the environment are maintained within predetermined acceptable ranges, e.g., for air temperature and/or humidity. For example, if air temperatures within the environment 100 are allowed to exceed acceptable ranges, processing operations of the IT devices may be impeded or throttled.

In embodiments, when operating power is provided to the IT devices 106 by the PDU 116, and the IT devices convert this operating power into thermal energy, the pumped two-phase cooling system 102 requires time to remove (122) this thermal energy from the environment. For example, as noted above, heat must first be transferred from the IT devices 106 to the secondary fluid network 114, transferred again to the primary fluid network 112 via the heat exchangers 120, and finally dissipated (122) outside the environment 100 by the chiller devices 110. Further, the CDUs 108 may respond to the heat load (as indicated by an increase in return temperatures from the secondary fluid network 114) by adjusting their setpoints, e.g., the outlet temperature and/or flow rate of fluid refrigerant circulating through the secondary fluid network, in order to absorb the additional heat.

Similarly, when the operating power drawn by one or more IT devices 106 surges or spikes, e.g., as is characteristic of HPC/AI applications, there will be a corresponding surge or spike in the heat load to be removed (122) from the environment 100 by the chiller devices 110. However, as noted above, under conventional cooling systems the chiller devices 110 have no advance warning of this heat surge or spike until its aftereffects arrive on a delayed basis, e.g., via sharp increases in the return temperatures of fluid refrigerant returning to the chiller devices via the primary fluid network 112. At this point, the chiller devices 110 must sharply adjust its own setpoints, e.g., the outlet temperatures of fluid refrigerant recirculating through the primary fluid network 112 or operating speeds of fans removing transferred heat (122) from the chiller devices. In the long term, drastic adjustments to chiller setpoints due to the inability to timely react to thermal load spikes or surges may degrade overall system stability, e.g., by introducing unwanted oscillation.

In embodiments, the pumped two-phase cooling system 102 provides for more efficient and responsive operation via a supervisory controller 118. For example, the supervisory controller 118 may include processors configured for real-time or near-real time monitoring of, as well as synchronous operation, of the PDUs 116, CDUs 108, and chiller devices 110. Further, information exchange between the PDUs 116 and chiller devices 110 may reduce or eliminate entirely the delay associated with thermal management of power spikes or surges characteristic of HPC/AI loads.

In embodiments, the supervisory controller 118 may receive regular, periodic reports on operating power provided to each rack 104 or IT device 106 by each PDU 116. Similarly, the supervisory controller 118 may receive regular reports as to the cooling capacity of the chiller devices 110. For example, the chiller devices 110 may report current outlet temperatures (e.g., degrees C) of fluid refrigerant leaving the chiller devices via the primary fluid network 112, current return temperatures (e.g., degrees C) of fluid refrigerant returning to the chiller devices via the primary fluid network, and the flow rate (e.g., liters per second, L/s) of the fluid refrigerant leaving the chiller devices. In some embodiments, the supervisory controller 118 may additionally monitor the CDUs 108 and secondary fluid network 114.

In embodiments, the supervisory controller 118 may correlate reported operating power provided by the PDU 116 (e.g., in kW; on a per-PDU basis, on a cumulative basis) with reported cooling capacity (e.g., also in kW, as derived from reported outlet/return temperatures and flow rate) provided by the chiller devices 110 as a moving window of time series data, as described in greater detail below. For example, viewing power distribution and cooling capacity as concurrent time series allows the supervisory controller 118 to observe trends in both of these parameters. Accordingly, a divergence or deviation of reported operating power from reported cooling capacity, as would be associated with a spike or surge in power distribution and a corresponding spike or surge in heat load, may be detected as soon as it occurs. Further, the supervisory controller 118 may direct the chiller devices 110 to proactively adjust cooling capacity such that the heat load is efficiently managed with minimal power cost and minimal risk of disruption to the pumped two-phase cooling system 102, e.g., due to condenser clogging of the chiller devices 110.

In embodiments, the supervisory controller 118 may be connected to, and may monitor, additional PDUs 116a and/or chiller devices 110 depending on the size of the pumped two-phase cooling system 102 and/or the data center environment 100 served thereby. For example, if the environment 100 incorporates multiple PDUs 116, 116a but the pumped two-phase cooling system 102 incorporates a single chiller device 110, the supervisory controller 118 may monitor power distribution on a cumulative basis. If the total power distribution among all PDUs 116, 116a sufficiently increases over time, or increases rapidly enough relative to the cooling capacity of the chiller device 110, the supervisory controller may take action. However, if one PDU 116 reports a significant increase in power distribution but the rate of increase in cumulative power distribution does not reach the threshold level, the supervisory controller 118 may not take action immediately.

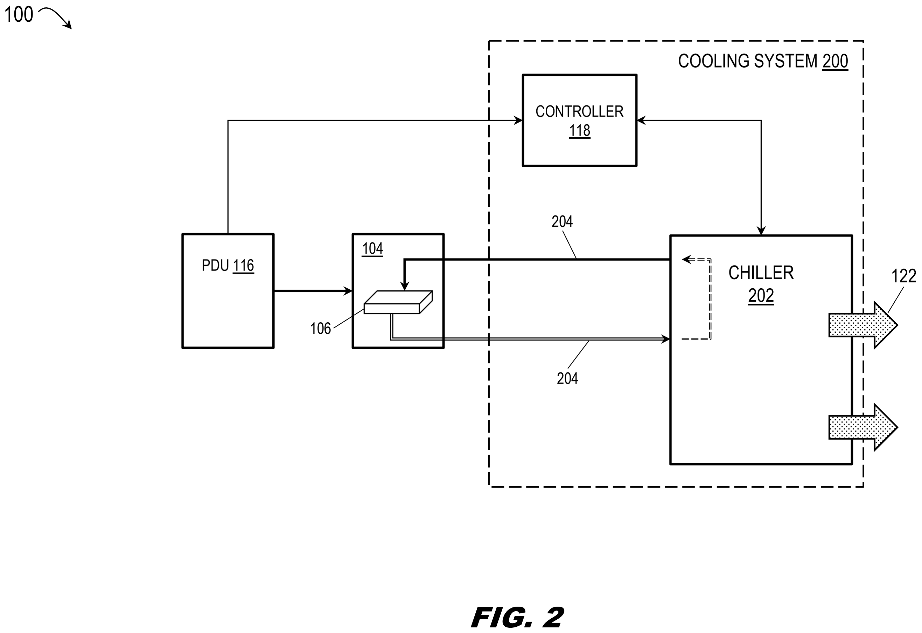

Referring now to FIG. 2, the cooling system 200 may be implemented and may function similarly to the pumped two-phase cooling system 102 of FIG. 1, except that the cooling system 200 may be a single-phase cooling system incorporating a chiller device 202 and fluid network 204. For example, the chiller device 202 may circulate a fluid refrigerant directly to and from the IT devices 106 via the fluid network 204.

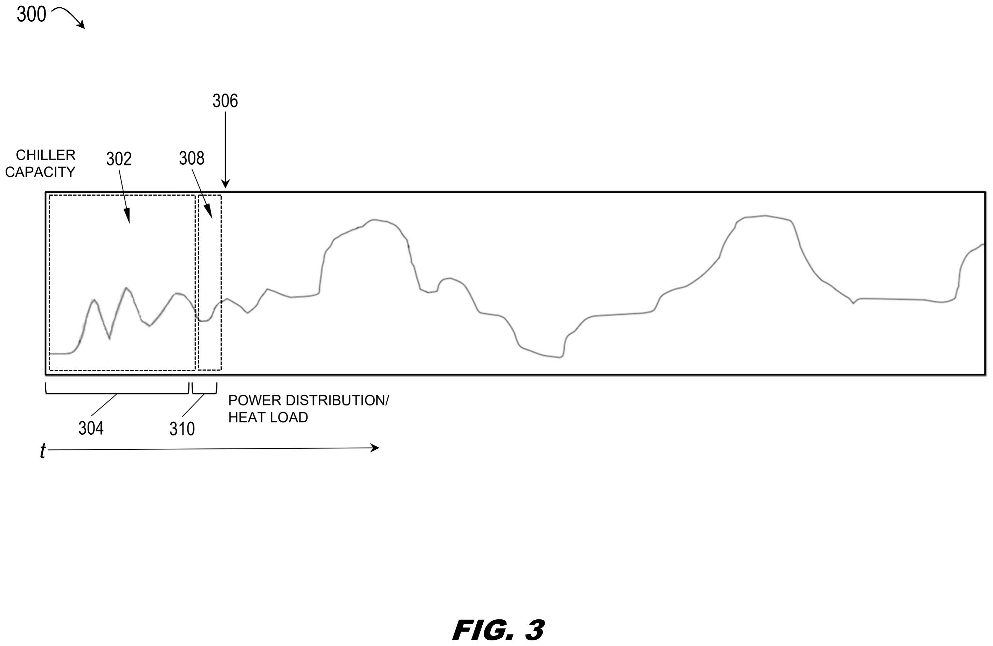

Referring now to FIG. 3, the graph 300 may represent parameters received by the supervisory controller 118 (FIG. 1), e.g., power distribution (kW) from the PDUs 116 (FIG. 1) and cooling capacity parameters (outlet temp, return temp, flow rate) from the chiller devices 110 (FIG. 1), and monitored over time.

In embodiments, the supervisory controller 118 may analyze power distribution and cooling capacity relative to each other over a moving window of time series data. For example, the blue moving window 302, or past moving window, may monitor trends in cooling capacity over a past time interval 304 prior to the current time 306. Similarly, the red moving window 308, or recent window, may monitor trends in power distribution (and corresponding heat loads) over a recent time interval 310 also prior to the current time 306 but shorter than the past time interval 304.

In embodiments, the blue and red moving windows 302, 308 provide a means for the supervisory controller 118 to detect significant rapid shifts in power distribution indicative of a load spike or surge, and for which the concurrent cooling capacity may be unprepared, e.g., when a heat load corresponding to the spike or surge in power reaches the chiller devices 110.

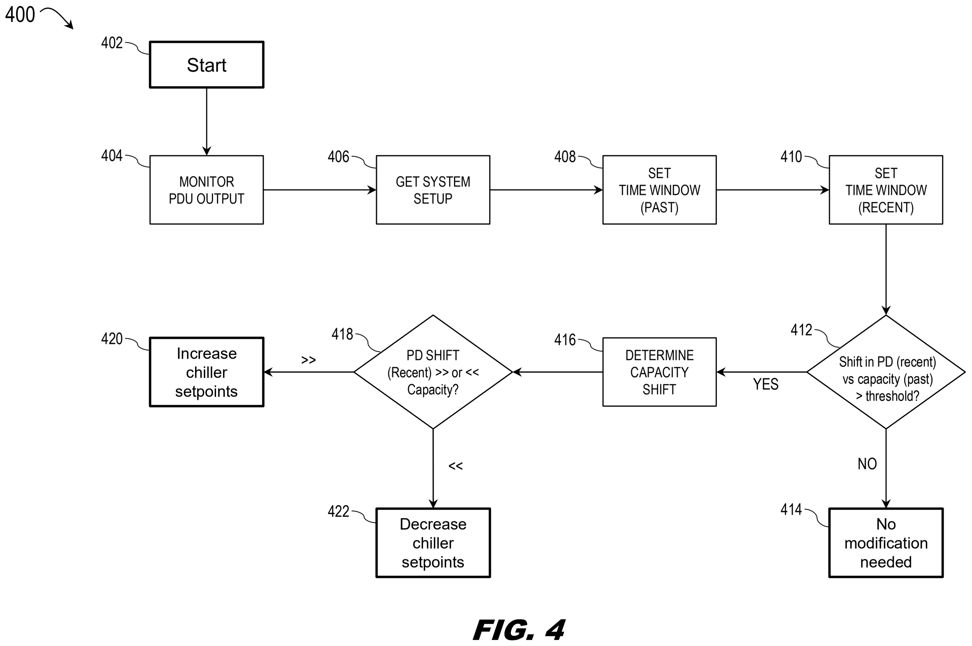

Referring now to FIG. 4, a process flow 400 for monitoring and thermal management of the environment 100 (FIG. 1) by the supervisory controller 118 (FIG. 1) of the pumped two-phase cooling system 102 (FIG. 1) is shown.

At point 402, the process starts.

At point 404, the supervisory controller 118 receives system parameters for the PDUs 116 and chiller devices 110 operating within the environment 100. For example, system parameters may include temperature requirements for the environment 100, load capacity of the PDUs 116, and/or cooling capacity of the chiller devices 110 and/or CDUs 108.

At point 406, the supervisory controller 118 monitors regular reports of power distribution from the PDUs 116.

At point 408, the duration of the past time interval 304, e.g., the blue moving window 302, is set.

Similarly, at point 410 the duration of the recent time interval 310, e.g., the red moving window 308, is set.

At point 412, a shift in power distribution/heat load over the recent time interval 310 relative to cooling capacity as monitored over the past time interval 304 may be observed.

At point 414, if no shift is observed, no modification to the cooling system is needed.

At point 416, if the shift in power distribution over the recent time interval 310 is observed to at least a threshold level relative to cooling capacity over the past time interval 304, the precise shift in cooling capacity to accommodate the shift in power distribution is calculated.

At point 418, the threshold level shift in power distribution over the recent time interval 310 relative to cooling capacity over the past time interval 304 may reflect power distribution significantly greater than, or significantly less then, the current cooling capacity.

At point 420, if the shift in power distribution exceeds current cooling capacity (indicative of an imminent heat load surge), the supervisory controller 118 may increase operational setpoints, e.g., outlet temperature and/or flow rate of fluid refrigerant leaving the chiller devices 110 via the primary fluid network 112 Further, the supervisory controller 118 may generate an alert indicative of the detected imminent heat load, which may include estimates of the magnitude of the shift and the corresponding shift in cooling capacity to address the heat load.

At point 422, if the shift in power distribution is significantly less than current cooling capacity, e.g., indicative of a significant drop in operating power across all PDUs 116, the supervisory controller 118 may decrease operational setpoints to conserve energy when the heat load to be transferred from the primary fluid network 112 is expected to require less cooling capacity than is currently deployed.

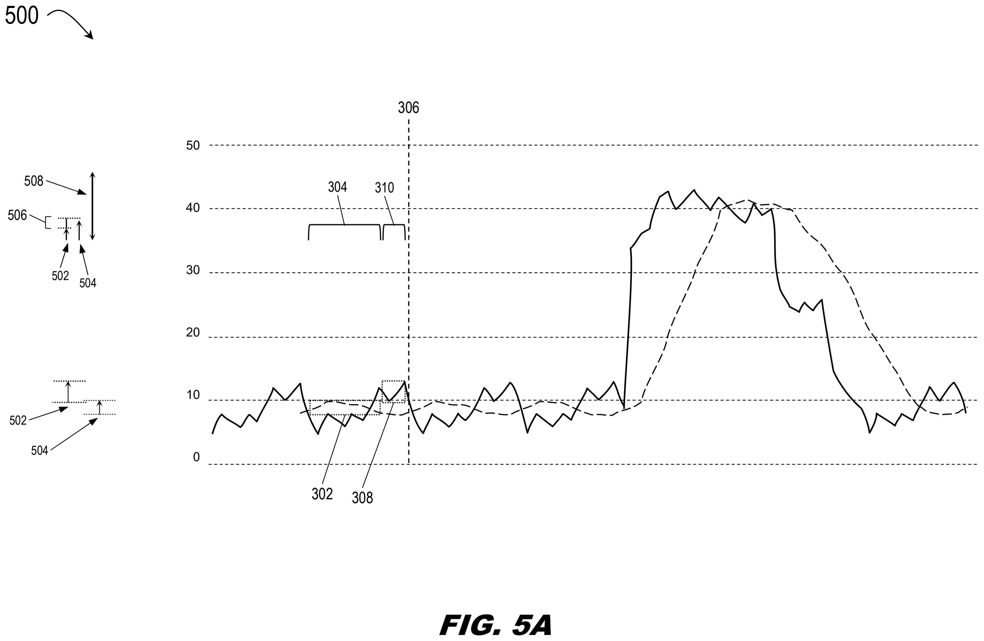

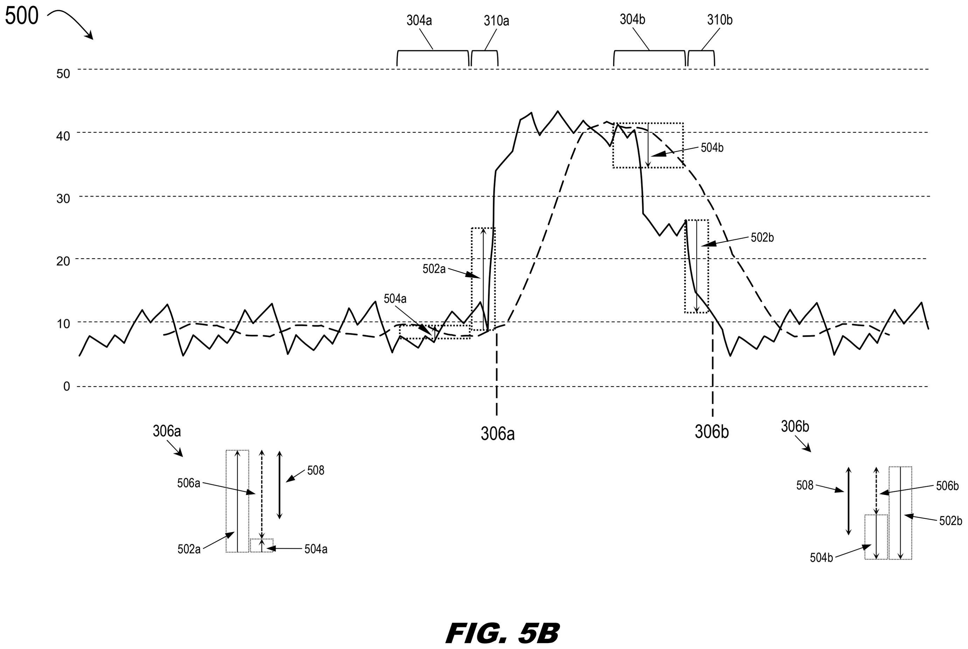

Referring now to FIGS. 5A and 5B, a graph 500 of power distribution 502 (blue line) correlated with cooling capacity 504 (orange line) is shown.

In embodiments, referring in particular to FIG. 5A, the red moving window 308 may track power distribution by the PDUs 116 (see FIG. 1) over the recent time interval 310 immediately prior to the current time 306, while the blue moving window 302 may track cooling capacity of the chiller device/s 110 (see FIG. 1) over the past time interval 304 prior to the recent time interval. For example, at the current time 306 the red moving window 308 may indicate a shift 502 in power distribution (specifically an increase) over the recent time interval 310, and the blue moving window 302 may indicate a shift 504 in cooling capacity (also an increase) over the past time interval 304. However, when the difference 506 between the power distribution shift 502 and the cooling capacity shift 504 is less than a threshold level 508, no action may be taken.

In embodiments, referring now to FIG. 5B, the difference 506a between the shift 502a in power distribution over the recent time interval 310a and the shift 504a in cooling capacity over the past time interval 304a relative to the current time 306a may exceed the threshold level 508, indicative of an imminent heat load beyond the ability of the current cooling capacity to dissipate. Accordingly, the supervisory controller 118 (see FIG. 1) may adjust the setpoints of one or more chiller devices 110 to increase cooling capacity, e.g., via lowering outlet temperatures or increasing fan speeds.

In embodiments, power distribution across multiple PDUs 116, 116a may be monitored on a cumulative basis. For example, if a shift in power distribution from any single PDU 116 fails to reach the threshold level 508, but the cumulative shift across all PDUs reaches the threshold level, modifications may be performed to address a corresponding shift in cooling capacity (whether positive or negative). By way of a nonlimiting example, the shift 502a in power distribution may represent a PDU 116 providing 100 kW of operating power but whose energy expectations suddenly spike to 130 kW. Accordingly, the chiller device/s 110 may have an imminent need to provide 30 kW additional cooling capacity. Assuming a fixed flow rate through the primary fluid network 112, a shift in output temperature setpoint/s may provide the necessary shift in cooling capacity, e.g., from an initial output temperature of 20° C to 17° C.

In embodiments, the supervisory controller 118 may likewise monitor for, and react to, a downward shift in power distribution to conserve energy. By way of another nonlimiting example, relative to the current time 306b, the shift 502b in power distribution may represent a decrease in operating power provided over the recent time interval 310b, and the shift 504b in cooling capacity a decrease over the past time interval 304b. When the difference 506b between the shifts 502b, 504b exceeds the threshold level 508 (although the difference as shown is less than the threshold level), the supervisory controller 118 may conclude that excess cooling capacity is being provided relative to the current heat load to remove from the primary fluid network 112, and may therefore adjust setpoints of the chiller device/s 110 to conserve energy, e.g., by gradually raising outlet temperature setpoints and/or fan speeds.

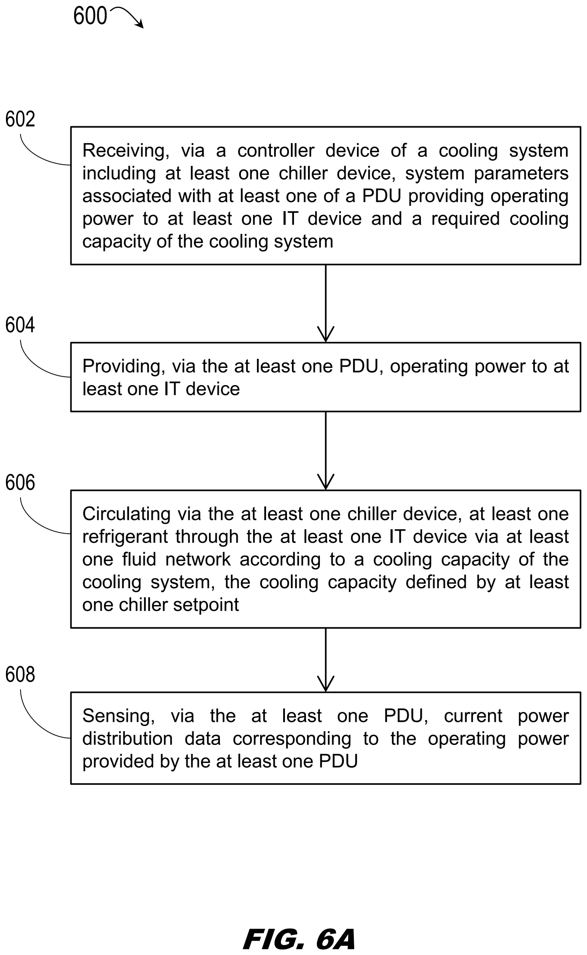

Referring now to FIG. 6A, the method 600 may be implemented by the pumped two-phase cooling system 102, single-phase cooling system 200, and/or the supervisory controller 118 of either cooling system, and may include the following steps.

At step 602, the supervisory controller receives system parameters associated with power distribution units (PDU) providing operating power to servers, switches, and other information technology (IT) devices within a data center environment, or with the cooling system and/or its component devices. For example, system parameters may include the power capacity of the PDUs, temperature and/or other acceptable environmental conditions for the data center environment, and/or the required cooling capacity for maintaining the IT devices and data center environment within these requirements. Further, system parameters may include expected cooling capacity requirements based on various power distribution levels.

At step 604, the PDUs provide operating power to the IT devices.

At step 606, chiller devices of the cooling system circulate a refrigerant through the IT devices to transfer generated heat therefrom. For example, in a single-phase cooling system a chiller device may circulate a fluid refrigerant through the IT devices via a single fluid network. In some embodiments, the cooling system is a two-phase cooling system wherein a coolant delivery unit (CDU; e.g., pumping unit) circulates a secondary fluid refrigerant through the IT devices via a secondary fluid network and then transfers the absorbed heat to a primary fluid network via heat exchangers. The primary fluid network returns a primary fluid refrigerant to a chiller device, which removes the transferred heat from the system and recirculates the primary fluid refrigerant to the CDU via the primary fluid network according to chiller setpoints (e.g., an outlet temperature and/or flow rate of the primary fluid refrigerant leaving the chiller device). In some embodiments, the refrigerant comes into direct thermal communication with chip assemblies, e.g., wherein cold plates absorb heat directly from chips or processors within the IT devices and transfer the absorbed heat to the fluid refrigerant. In any case, fluid refrigerants may be circulated through a fluid network according to chiller device setpoints. For example, in order to maintain the data center environment within a predetermined temperature range, a particular configuration of cooling system may circulate fluid refrigerant according to a desired outlet temperature and/or flow rate (e.g., of refrigerant leaving the chiller devices) and/or return temperature (e.g., of refrigerant returning to the devices with transferred thermal energy). Further, initial chiller device setpoints may be determined based on an expected power distribution level.

At step 608, the PDUs may sense, and report to the supervisory controller, power distribution data associated with the current power distribution of the PDUs within the data center environment, and corresponding to the heat load based on said power distribution (e.g., the operating power being converted to thermal energy by the downstream IT devices). For example, the supervisory controller may monitor trending power distribution over a recent moving window prior to the current time.

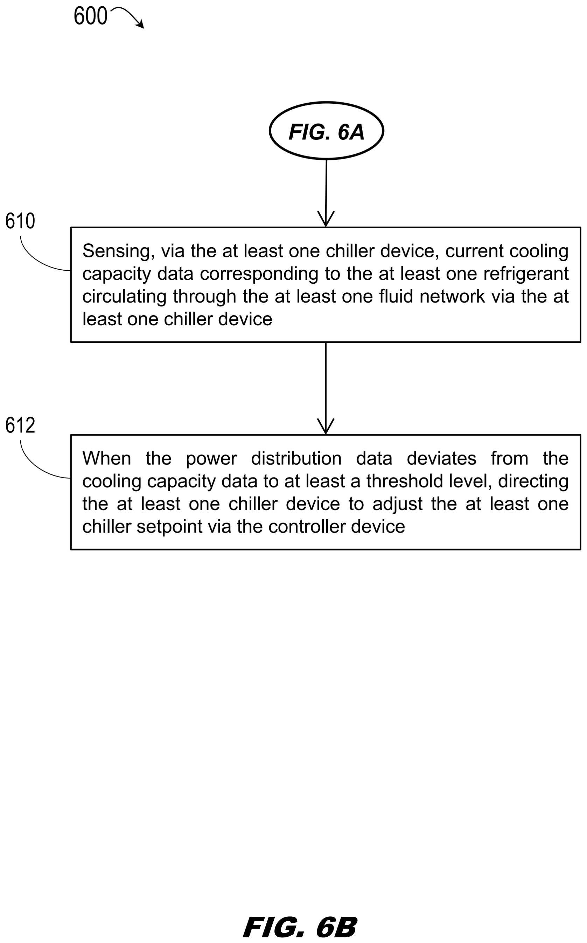

Referring also to FIG. 6B, at step 610, the chiller devices may sense, and report to the supervisory controller, current cooling capacity information from the chiller device/s. For example, the chiller device/s may report current outlet temperatures (for fluid refrigerant leaving the chiller device via the primary fluid network), current return temperatures, and current flow rates. Further, the supervisory controller may derive current cooling capacity from these received parameters and monitor capacity over a longer past moving window (e.g., relative to the recent moving window for trending power distribution) prior to the current time.

At step 612, when trending power distribution deviates from trending cooling capacity to at least a threshold level, the supervisory controller directs the chiller device/s to adjust one or more setpoints (e.g., outlet temperature, flow rate) based on an imminent surge or drop in power distribution. For example, the reported cooling capacity may correspond to an expected power distribution level while the actual reported power distribution may be indicative of an imminent power surge and corresponding heat load, which the current cooling capacity may not be able to efficiently manage and which may not otherwise be detected until excess transferred heat (e.g., converted from the increased operating power) is returned to the chiller devices via the fluid network. Accordingly, the cooling system controller may increase the flow rate or decrease the outlet temperature of the fluid refrigerant in order to proactively meet the imminent heat load. Conversely, where an imminent drop in power distribution is indicated (relative to the expected power distribution), the cooling system controller may direct chiller devices to decrease flow rate and/or increase outlet temperature in order to conserve excess cooling capacity where it may not currently be needed.

### CONCLUSION

Embodiments of the inventive concepts disclosed herein may provide more efficient thermal management by eliminating inertia within the cooling system, responding proactively to imminent surges or drops in operating power, rather than reacting to the resulting shifts in heat load when they are finally detected by the downstream chiller devices.

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system (102), comprising:
at least one information technology "IT" device (106) disposed in an environment (100);
at least one power distribution unit "PDU" (116) configured for providing operating power to the at least one IT device;
at least one cooling device (110) fluidly coupled to the at least one IT device via at least one fluid network (112), the at least one cooling device configured for:
transferring heat from the at least one IT device by circulating a refrigerant through the at least one IT device via the at least one fluid network according to a chiller capacity defined by at least one chiller setpoint;
and
sensing at least one cooling parameter corresponding to the circulating of the refrigerant;
and
a controller (118) operatively coupled to the at least one PDU and to the at least one cooling device, the controller including at least one processor and configured for:
sensing, via the at least one PDU, power distribution data associated with the operating power provided to the at least one IT device and with a corresponding heat load;
receiving, from the at least one cooling device, cooling capacity data based on the at least one cooling parameter; and
when the received power distribution data deviates from the received cooling capacity data to at least a threshold level, directing the at least one cooling device to adjust the at least one chiller setpoint.

2. The cooling system of Claim 1, wherein the controller is configured for:
monitoring the received cooling capacity data over a first moving time window; and
monitoring the received power distribution data over a second moving time window.

3. The cooling system of Claim 2, wherein the first moving time window is longer than the second moving time window.

4. The cooling system of any preceding Claim, wherein:
the at least one chiller setpoint includes at least one desired outlet temperature of the refrigerant leaving the at least one cooling device;
and
wherein the cooling capacity data includes at least one current outlet temperature of the refrigerant leaving the at least one cooling device.

5. The cooling system of any preceding Claim, wherein:
the at least one chiller setpoint includes at least one desired flow rate of the refrigerant leaving the at least one cooling device;
and
wherein the cooling capacity data includes at least one current flow rate of the refrigerant leaving the at least one cooling device.

6. The cooling system of any preceding Claim, wherein:
the power distribution data includes a cumulative power distribution among two or more PDUs;
and
wherein the controller is configured for directing the at least one cooling device to adjust the at least one chiller setpoint when the cumulative power distribution data deviates from the received cooling capacity data to at least a threshold level.

7. The cooling system of any preceding Claim, wherein:
the at least one IT device includes at least one chip assembly;
and
wherein the at least one fluid network is in thermal communication with the at least one chip assembly.

8. The cooling system of any preceding Claim, wherein the controller is configured for:
correlating the received cooling capacity data to an equivalent power distribution level;
and
when the received power distribution data deviates from the equivalent power distribution level to at least a threshold level, directing the at least one cooling device to adjust the at least one chiller setpoint.

9. The cooling system of any preceding Claim, wherein the cooling system is a two-phase cooling system, and wherein the at least one cooling device includes:
at least one coolant distribution unit "CDU" (108) fluidly coupled to the at least one IT device via a secondary fluid network (114), the at least one CDU configured for:
absorbing heat from the at least one IT device by circulating a secondary refrigerant through the at least one IT device via the secondary fluid network;
and
transferring, via at least one heat exchanger, the absorbed heat from the secondary refrigerant to a primary refrigerant circulating through a primary fluid network;
and
at least one chiller device fluidly coupled to the at least one CDU via the primary fluid network, the at least one chiller device configured for:
dissipating the absorbed heat transferred to the primary fluid network external to the environment;
and
returning the primary fluid refrigerant to the at least one CDU via the primary fluid network according to the cooling capacity.

10. A method (600) for thermal management, comprising:
receiving (602), via a controller device of a cooling system including at least one chiller device, system parameters associated with at least one of a power distribution unit "PDU" providing operating power to at least one information technology "IT" device and a required cooling capacity of the cooling system;
providing (604), via the at least one PDU, operating power to the at least one IT device;
circulating (606), via the at least one chiller device, at least one refrigerant through the at least one IT device via at least one fluid network according to a cooling capacity of the cooling system, the cooling capacity defined by at least one chiller setpoint;
sensing (608), via the at least one PDU, current power distribution data corresponding to the operating power provided by the at least one PDU;
sensing (610), via the at least one chiller device, current cooling capacity data corresponding to the at least one refrigerant circulating through the at least one fluid network via the at least one chiller device;
and
when the power distribution data deviates from the cooling capacity data to at least a threshold level, directing (612) the cooling system to adjust the at least one chiller setpoint via the controller device.

11. The method of Claim 10, wherein:
receiving the power distribution data includes monitoring the power distribution data over a first moving time window;
and
wherein receiving the cooling capacity data includes monitoring the cooling capacity data over a second moving time window.

12. The method of Claim 11, wherein the second moving time window is longer than the first moving time window.

13. The method of any of Claims 10 to 12, wherein directing the at least one chiller device to adjust the at least one chiller setpoint via the controller device includes:
directing the cooling system to adjust an outlet temperature of the at least one refrigerant leaving the at least one chiller device, and/or wherein directing the at least one chiller device to adjust the at least one chiller setpoint via the controller device includes:
directing the at least one chiller device to adjust a flow rate of the at least one refrigerant leaving the chiller device.

14. The method of any of Claims 10 to 13, wherein:
receiving the power distribution data corresponding to the operating power provided by the at least one PDU includes:
determining, via the controller device, a cumulative power distribution based on the operating power provided by each of two or more PDUs;
and
wherein directing the at least one chiller device to adjust the at least one chiller setpoint via the controller device includes:
directing the at least one chiller device to adjust the at least one chiller setpoint via the controller device when the cumulative power distribution data deviates from the cooling capacity data to at least a threshold level.

15. The method of any of Claims 10 to 14, wherein:
receiving, via the controller device, the current cooling capacity data includes correlating the current cooling capacity data to an equivalent power distribution level manageable by the cooling system;
and
wherein directing the at least one chiller device to adjust the at least one chiller setpoint via the controller device includes directing the at least one chiller device to adjust the at least one chiller setpoint via the controller device when the equivalent power distribution level deviates from the power distribution data to at least the threshold level, and/or wherein circulating at least one refrigerant through the at least one IT device via at least one secondary fluid network includes:
circulating, via the at least one fluid network, the at least one refrigerant into direct thermal communication with at least one chip assembly disposed within the at least one IT device.
